# EUROPEAN PATENT APPLICATION

(11) **EP 3 875 267 A1**
(43) Date of publication of application: **08.09.2021**
(21) Application number: 19878055.3
(22) Date of filing: 31.10.2019
(51) Int. Cl.: B32B 9/00, H01L 23/36

(54) **METAL LAYER-INCLUDING CARBONACEOUS MEMBER AND HEAT CONDUCTION PLATE**

(30) Priority: 31.10.2018 JP 2018206000
(71) Applicant: Mitsubishi Materials Corporation, Tokyo 100-8117 (JP)
(72) Inventor: KITA, Koichi, Tokyo 100-8117 (JP); NAGASE, Toshiyuki, Naka-shi, Ibaraki 311-0102 (JP); NAKAYA, Kiyotaka, Naka-shi, Ibaraki 311-0102 (JP); IWATA, Kotaro, Naka-shi, Ibaraki 311-0102 (JP)
(74) Representative: Gille Hrabal Partnerschaftsgesellschaft mbB Patentanwälte
(86) International application number: PCT/JP2019/042914
(87) International publication number: WO 2020/091008

(57) **Abstract**

A carbonaceous member (21) contains graphene aggregates formed by deposition of a single layer or multiple layers of graphene, and flat graphite particles, and has a structure in which the flat graphite particles are laminated with the graphene aggregate as a binder so that basal surfaces of the graphite particles overlap with one another, and the basal surfaces of the flat graphite particles are oriented in one direction. A metal layer (25) includes a metal plating layer (26) directly formed on a surface (edge lamination surface) to which edge surfaces of the graphite particles laminated in the carbonaceous member (21) are directed, and the metal plating layer (26) is made of a metal having a thermal conductivity of 50 W/(m-k) or greater.

## Description

### TECHNICAL FIELD

The present invention relates to, for example, a metal layer-including carbonaceous member which can efficiently transfer heat from a heating element and is particularly suitable as a heat conduction member, and a heat conduction plate formed of the metal layer-including carbonaceous member.

Priority is claimed on Japanese Patent Application No. 2018-206000, filed October 31, 2018, the content of which is incorporated herein by reference.

### BACKGROUND ART

For example, various devices mounted with a heating element (power semiconductor element and LED element) such as power modules and LED modules are provided with a heat sink to efficiently radiate the heat generated from the heating element, and a heat conduction plate disclosed in, for example, Patent Documents 1 to 3 may be disposed between the heating element (element and substrate mounted with element) and the heat sink.

Patent Document 1 discloses a power module including an insulating plate and a surface conductor formed of a plate-like two-dimensional super heat transfer conductor provided on a main surface of the insulating plate. The two-dimensional super heat transfer conductor has a structure in which multiple single graphene layers are deposited in a growth axis direction, and has an excellent heat conduction property in a surface orthogonal to the growth axis direction. In Patent Document 1, titanium is vapor-deposited on the surface of the two-dimensional super heat transfer conductor, and then a Ni-P plating layer is formed.

Patent Document 2 discloses an anisotropic heat conduction element having: a structure in which graphene sheets are laminated along a surface intersecting a contacting surface in contact with a heat source; and a support member covering a peripheral portion of the structure. A titanium layer as an active species is formed on the surfaces of the structure and the support member, and a nickel layer or a copper layer is formed thereon. In this Patent Document 2, "PYROID HT" (trade name) manufactured by MINTEQ International Inc. is applied as the structure.

Patent Document 3 discloses an anisotropic heat conduction element which has: a structure in which graphene sheets are laminated along a first direction; and an intermediate member bonded to an end surface of the structure in a second direction intersecting the first direction, and the intermediate member is pressure-bonded to the end surface via an insert material containing at least titanium. In this Patent Document 3, "PYROID HT" (trade name) manufactured by MINTEQ International Inc. is also applied as the structure.

### [Citation List]

### [Patent Documents]

[Patent Document 1] Japanese Patent No. 6299407
[Patent Document 2] Japanese Unexamined Patent Application, First Publication No. 2011-023670
[Patent Document 3] Japanese Unexamined Patent Application, First Publication No. 2012-238733

### SUMMARY OF INVENTION

### TECHNICAL PROBLEM

In the above-described Patent Documents 1 to 3, a metal layer is formed on the surface of the carbonaceous member in order to protect the carbonaceous member in which the graphenes are laminated, or to improve the joinability with other members.

In the above-described Patent Documents 1 to 3, in the formation of a metal layer on the surface of the carbonaceous member in which the graphenes are laminated, a titanium layer is formed on the surface of the carbonaceous member, and a nickel layer or a copper layer is formed on the titanium layer. That is, the bonding strength between the carbonaceous member and the metal layer is secured by interposing the titanium layer which is an active metal.

However, titanium has a relatively low thermal conductivity of 17 W/(m-K). Accordingly, the titanium layer interposed between the carbonaceous member and the metal layer provides heat resistance, and thus even in a case where the carbonaceous member is disposed so that the basal surface of the graphene extends in a thickness direction of the heat conduction plate, heat may not be efficiently conducted in the thickness direction.

The present invention is contrived in view of the above-described circumstances, and an object thereof is to provide a metal layer-including carbonaceous member in which a metal layer and a carbonaceous member are firmly bonded and which can efficiently conduct heat, and a heat conduction plate using the metal layer-including carbonaceous member.

### SOLUTION TO PROBLEM

A metal layer-including carbonaceous member (carbonaceous member having a metal layer) according to an aspect of the present invention includes: a carbonaceous member; and a metal layer formed on at least a part of a surface of the carbonaceous member, the carbonaceous member contains graphene aggregates formed by deposition of a single layer or multiple layers of graphene, and flat graphite particles, and has a structure in which the flat graphite particles are laminated with the graphene aggregate as a binder so that basal surfaces of the graphite particles overlap with one another, and the basal surfaces of the flat graphite particles are oriented in one direction, the metal layer includes a metal plating layer directly formed on a surface (called edge lamination surface) to which edge surfaces of the graphite particles laminated in the carbonaceous member are directed, and the metal plating layer is made of a metal having a thermal conductivity of 50 W/(m- K) or greater.

In the metal layer-including carbonaceous member, appropriate irregularities are formed on the surface (edge lamination surface) to which the edge surfaces of the graphite particles are directed, and the metal layer includes the metal plating layer formed on the surface (edge lamination surface) to which the edge surfaces of the graphite particles laminated are directed. Accordingly, the plating metal constituting the metal plating layer sufficiently penetrates into the irregularities existing on the surface layer portion of the carbonaceous member, and the bonding strength between the metal plating layer and the carbonaceous member is improved. Accordingly, it is not necessary to interpose titanium or the like, which is an active metal, between the carbonaceous member and the metal layer.

In addition, since the metal plating layer is made of a metal having a thermal conductivity of 50 W/(m- K) or greater, the metal plating layer does not provide large heat resistance. Accordingly, the heat from the heating element disposed on the metal layer can be efficiently conducted to the carbonaceous member side through the metal layer.

In the metal layer-including carbonaceous member according to this aspect, the metal layer preferably includes the metal plating layer and a metal member layer formed of a metal member bonded to the metal plating layer. In this case, since the metal layer includes the metal plating layer and the metal member layer, the thickness of the metal layer is secured by the metal member layer, the heat can be sufficiently diffused along the metal layer, and the heat conduction characteristics can be further improved. Since the bonding between metal plating layer and the metal member layer is bonding between the metals, sufficient bonding strength can be secured.

In the metal layer-including carbonaceous member according to this aspect, a bonding layer formed of a sintered body of a metal is preferably formed between the metal plating layer and the metal member layer. In this case, since the bonding layer formed between the metal plating layer and the metal member layer is formed of a sintered body of a metal, the thermal stress generated due to a difference in thermal expansion coefficient between the carbonaceous member and the metal member layer caused in a case where thermal cycle is loaded on the metal layer-including carbonaceous member can be relaxed in the bonding layer, and the damage to the metal layer-including carbonaceous member can be suppressed.

In the metal layer-including carbonaceous member according to this aspect, an arithmetic average height Sa of the edge lamination surface is preferably 1.1 µm or greater, and a maximum height Sz of the edge lamination surface is preferably 20 µm or greater. In a case where these ranges are satisfied, the metal plating layer is more firmly bonded to the irregularities of the edge lamination surface, whereby the bonding strength between the metal plating layer and the carbonaceous member can be further improved. The arithmetic average height Sa represents an average of the absolute values of the height differences at the respective points in the measurement surface with respect to the average height of the measurement region face. The maximum height Sz represents a distance from the highest point to the lowest point of the surface of the measurement region face.

The arithmetic average height Sa of the edge lamination surface is more preferably 1.1 µm or greater and 5 µm or less, and the maximum height Sz of the edge lamination surface is more preferably 20 µm or greater and 50 µm or less. The arithmetic average height Sa of the edge lamination surface is even more preferably 1.1 µm or greater and 3.0 µm or less, and the maximum height Sz of the edge lamination surface is even more preferably 20 µm or greater and 40 µm or less. A reference surface for a case where the arithmetic average height Sa and the maximum height Sz of the edge lamination surface are measured may have a size of, for example, 3.02 mm × 3.02 mm. For the measurement of the arithmetic average height Sa and the maximum height Sz, a method of converting interference fringe brightness and darkness information obtained by a white interference microscope into height information may be used.

In the metal layer-including carbonaceous member according to this aspect, in order to set each of the arithmetic average height Sa and the maximum height Sz of the edge lamination surface within the predetermined range, the edge lamination surface may be previously roughened by a roughening treatment such as an ozone treatment. In a case where the edge lamination surface is subjected to an ozone treatment, the metal plating layer is more firmly bonded to the irregularities of the edge lamination surface roughened by the ozone treatment, whereby the bonding strength between the metal plating layer and the carbonaceous member can be further improved.

A heat conduction plate according to another aspect of the present invention which diffuses heat from a heating element mounted on a main surface in a surface direction and conducts the heat in a thickness direction includes: the above-described metal layer-including carbonaceous member, the carbonaceous member is disposed so that the basal surfaces of the graphite particles extend in the thickness direction of the carbonaceous member, and the metal plating layer is formed on the main surface of the carbonaceous member to which the edge surfaces of the graphite particles are directed.

According to the heat conduction plate, the heat conduction plate is formed of the above-described metal layer-including carbonaceous member, and the carbonaceous member is disposed so that the basal surfaces of the graphite particles extend in the thickness direction of the carbonaceous member. Accordingly, the thermal conductivity of the carbonaceous member in the thickness direction increases. Since the metal plating layer is formed on the main surface of the carbonaceous member to which the edge surfaces of the graphite particles are directed, the heat from the heating element mounted on the main surface can be efficiently diffused in the surface direction in the metal layer having the metal plating layer, and the heat can be efficiently conducted in the thickness direction. Since the metal plating layer is made of a metal having a thermal conductivity of 50 W/(m- K) or greater and is formed on the main surface to which the edge surfaces of the graphite particles are directed, the metal plating layer does not provide heat resistance. Instead, and the heat can be efficiently conducted in the thickness direction.

### ADVANTAGEOUS EFFECTS OF INVENTION

According to the present invention, it is possible to provide a metal layer-including carbonaceous member in which a metal layer and a carbonaceous member are firmly bonded and which can efficiently conduct heat, and a heat conduction plate using the metal layer-including carbonaceous member.

### BRIEF DESCRIPTION OF DRAWINGS

Fig. 1 is a schematic illustration of a power module using a heat conduction plate (metal layer-including carbonaceous member) according to an embodiment of the present invention.
Fig. 2 is a schematic illustration of the heat conduction plate (metal layer-including carbonaceous member) according to the embodiment of the present invention.
Fig. 3 is an observation result of a bonding interface between a carbonaceous member and a metal plating layer of the heat conduction plate (metal layer-including carbonaceous member) according to the embodiment of the present invention.
Fig. 4 is a schematic diagram of the bonding interface between the carbonaceous member and the metal plating layer of the heat conduction plate (metal layer-including carbonaceous member) according to the embodiment of the present invention.
Fig. 5 is a flowchart showing a method of producing the heat conduction plate (metal layer-including carbonaceous member) according to the embodiment of the present invention.
Fig. 6 is a schematic illustration of a heat conduction plate (metal layer-including carbonaceous member) according to another embodiment of the present invention.
Fig. 7 is a schematic illustration of another power module using the heat conduction plate (metal layer-including carbonaceous member) according to the embodiment of the present invention.
Fig. 8 is a schematic illustration of a further power module using the heat conduction plate (metal layer-including carbonaceous member) according to the embodiment of the present invention.

### DESCRIPTION OF EMBODIMENTS

Hereinafter, embodiments of the present invention will be described with reference to the accompanying drawings. Each of the following embodiments does not limit the present invention unless otherwise specified. In the drawings used in the following description, in order to make the characteristics of the present invention easy to understand, the main parts may be shown in an enlarged manner, and dimensional ratios and the like of the respective constituent elements are not necessarily the same as the actual ratios and the like.

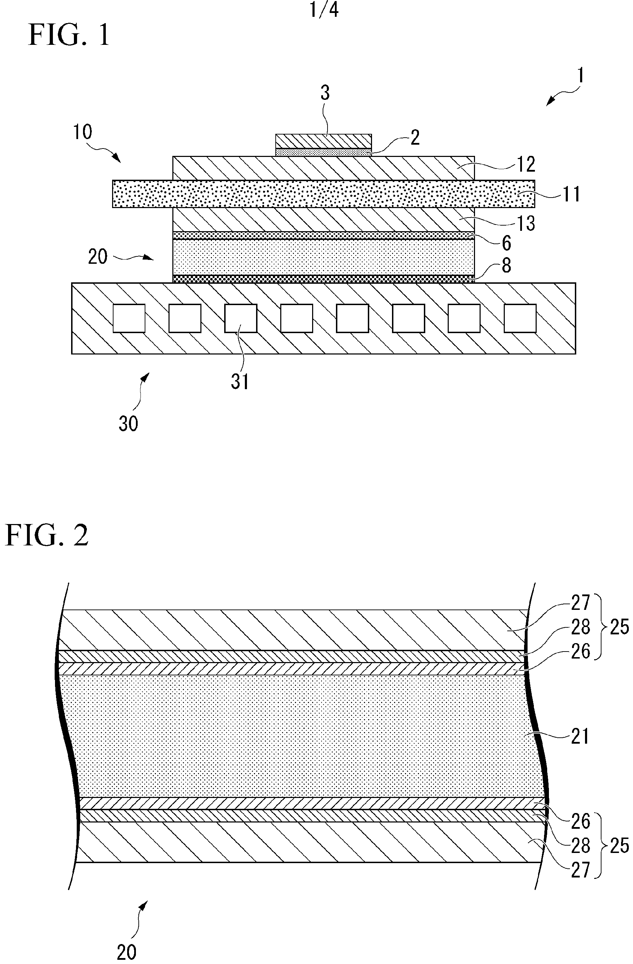

First, a power module using a heat conduction plate (metal layer-including carbonaceous member) according to an embodiment of the present invention will be described with reference to Figs. 1 to 5.

A power module 1 shown in Fig. 1 includes an insulating circuit board 10, a semiconductor element 3 bonded to one surface side (upper side in Fig. 1) of the insulating circuit board 10 via a solder layer 2, a heat conduction plate 20 disposed on the other surface side (lower side in Fig. 1) of the insulating circuit board 10, and a heat sink 30 disposed on the other surface side of the heat conduction plate 20.

The insulating circuit board 10 includes an insulating layer 11, a circuit layer 12 disposed on one surface of the insulating layer 11 (upper surface in Fig. 1), and a heat transfer layer 13 disposed on the other surface (lower surface in Fig. 1) of the insulating layer 11.

The insulating layer 11 prevents electrical connection between the circuit layer 12 and the heat transfer layer 13, and in this embodiment, the insulating layer is made of ceramics having a high insulating property such as aluminum nitride (AlN), aluminum oxide (Al₂O₃), and silicon nitride (Si₃N₄). A thickness of the insulating layer 11 is set within a range of 0.2 to 1.5 mm, and in this embodiment, the thickness may be set to 0.635 mm.

The circuit layer 12 is formed by bonding a metal plate having an excellent conductive property to one surface of the insulating layer 11. In this embodiment, a copper plate made of copper or a copper alloy, specifically, a rolled plate of oxygen-free copper is used as the metal plate constituting the circuit layer 12. The circuit layer 12 has a circuit pattern formed thereon, and one surface (upper surface in Fig. 1) thereof is a mounting surface on which the semiconductor element 3 is mounted.

A thickness of the metal plate (copper plate) serving as the circuit layer 12 is set within a range of 0.1 mm or greater and 1.0 mm or less, and in this embodiment, the thickness may be set to 0.6 mm.

The heat transfer layer 13 is formed by bonding a metal plate having an excellent heat conduction property to the other surface of the insulating layer 11. In this embodiment, a copper plate made of copper or a copper alloy, specifically, a rolled plate of oxygen-free copper is used as the metal plate constituting the heat transfer layer 13.

A thickness of the metal plate (copper plate) serving as the heat transfer layer 13 is set within a range of 0.1 mm or greater and 1.0 mm or less, and in this embodiment, the thickness may be set to 0.6 mm.

The insulating layer 11 made of ceramics and the copper plates serving as the circuit layer 12 and the heat transfer layer 13, respectively, can be bonded to each other by a brazing method using an active metal, a DBC method, or the like.

The heat sink 30 is provided to cool the above-described insulating circuit board 10, and has a structure provided with a plurality of flow paths 31 for flowing a cooling medium (for example, cooling water).

The heat sink 30 is preferably made of a material having a good heat conduction property, such as aluminum or an aluminum alloy and copper or a copper alloy, and in this embodiment, the heat sink may be made of oxygen-free copper.

The semiconductor element 3 is made of, for example, a semiconductor material such as Si or SiC. The semiconductor element 3 is mounted on the circuit layer 12 via, for example, a solder layer 2 made of a solder material based on Sn-Ag, Sn-In, or Sn-Ag-Cu.

The heat conduction plate 20 according to this embodiment is interposed between the insulating circuit board 10 and the heat sink 30. As will be described later, the outermost layers of both the main surfaces of the heat conduction plate 20 are made of oxygen-free copper, and the heat transfer layer 13 of the insulating circuit board 10 made of copper and the heat sink 30 are bonded via solder layers 6 and 8 made of, for example, a solder material based on Sn-Ag, Sn-In, or Sn-Ag-Cu as shown in Fig. 1.

As shown in Fig. 2, the heat conduction plate 20 according to this embodiment includes a plate body 21 formed of a carbonaceous member, and a metal layer 25 formed on both main surfaces (edge lamination surfaces) of the plate body 21. The carbonaceous member constituting the plate body 21 contains graphene aggregates formed by deposition of a single layer or multiple layers of graphene, and flat graphite particles, and has a structure in which the flat graphite particles are laminated with the graphene aggregate as a binder so that the basal surfaces of the graphite particles overlap with one another.

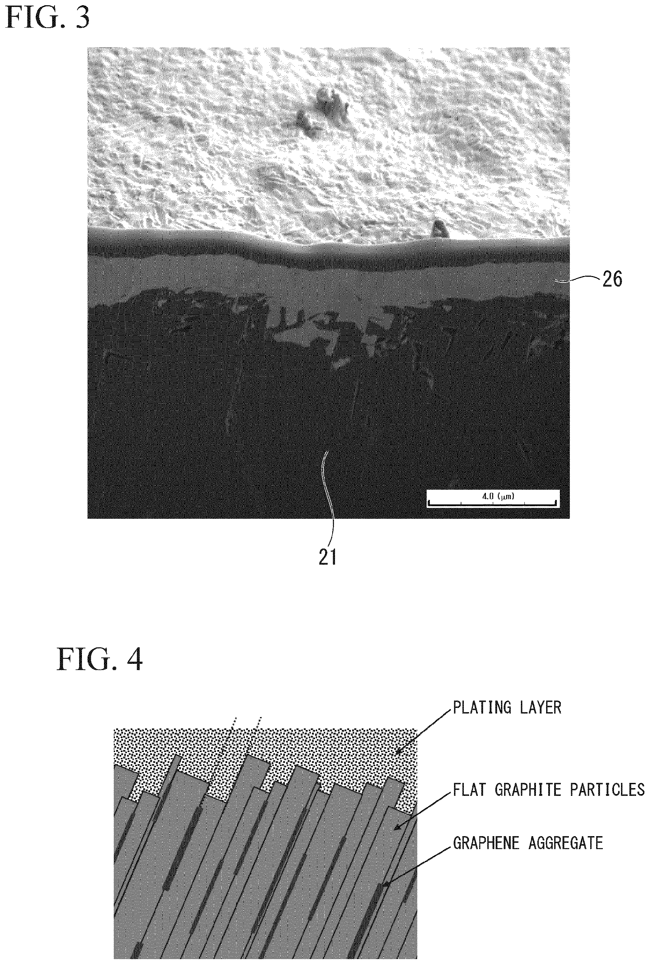

As shown in Fig. 4, the flat graphite particles have a basal surface on which a carbon hexagonal net surface appears and an edge surface on which an end portion of the carbon hexagonal net surface appears. As the flat graphite particles, scaly graphite, scale-like graphite, earthy graphite, flaky graphite, kish graphite, pyrolytic graphite, highly-oriented pyrolytic graphite, and the like can be used. The average particle size of the graphite particles viewed toward the basal surface is preferably within a range of 10 µm or greaer and 1,000 µm or less, and more preferably within a range of 50 µm or greater and 800 µm or less in a case where the size is measured by, for example, a line segment method. The heat conduction property is improved by adjusting the average particle size of the graphite particles within the above range.

The average thickness of the graphite particles is preferably within a range of 1 µm or greater and 50 µm or less, and more preferably within a range of 1 µm or greater and 20 µm or less in a case where the thickness is measured by, for example, a line segment method. The orientation of the graphite particles is appropriately adjusted by adjusting the thickness of the graphite particles within the above range.

By adjusting the thickness of the graphite particles within a range of 1/1,000 to 1/2 of the particle size viewed toward the basal surface, an excellent heat conduction property is obtained and the orientation of the graphite particles is appropriately adjusted. The thickness of the graphite particles is more preferably within a range of 1/1,000 to 1/500 of the particle size viewed toward the basal surface.

The graphene aggregate is a deposit of a single layer or multiple layers of graphene, and the number of multiple layers of graphene laminated is, for example, 100 layers or less, and preferably 50 layers or less. The graphene aggregate can be produced by, for example, dripping a graphene dispersion obtained by dispersing a single layer or multiple layers of graphene in a solvent containing a lower alcohol or water onto filter paper, and depositing the graphene while separating the solvent.

The average particle size of the graphene aggregate is preferably within a range of 1 µm or greater and 1,000 µm or less in a case where the size is measured by, for example, a line segment method. The heat conduction property is improved by adjusting the average particle size of the graphene aggregate within the above range. The average particle size of the graphene aggregate is more preferably 50 µm or greater and 800 µm or less.

The thickness of the graphene aggregate is preferably within a range of 0.05 µm or greater and less than 50 µm in a case where the thickness is measured by, for example, a line segment method. The strength of the carbonaceous member is secured by adjusting the thickness of the graphene aggregate within the above range. The thickness of the graphene aggregate is more preferably 1 µm or greater and 20 µm or less.

In this embodiment, the carbonaceous member constituting the plate body 21 is disposed so that the basal surfaces of the graphite particles laminated extend along a thickness direction of the plate body 21. Accordingly, as shown in Fig. 4, the edge surfaces of the graphite particles are directed to the main surface (edge lamination surface) of the plate body 21. As described above, in a case where the edge surfaces of the graphite particles are directed to the main surface of the plate body 21, irregularities are formed on the main surface (edge lamination surface) of the plate body 21. There is a high probability that protrusions and recesses of the main surface (edge lamination surface) of the plate body 21 have a U-shaped cross section with a pair of substantially parallel surfaces. Accordingly, a high anchor effect is obtained due to entering of the metal layer 25 into the irregular portion, and the bonding strength between the edge lamination surface and the metal layer 25 is increased. In order to securely form the irregular portion of the edge lamination surface, an ozone treatment can be performed to increase the surface roughness.

The metal layer 25 according to this embodiment includes a metal plating layer 26 directly formed on the main surface of the plate body 21, a metal member layer 27 formed of a metal member bonded to the metal plating layer 26, and a bonding layer 28 formed between the metal member layer 27 and the metal plating layer 26. In the present invention, the metal layer 25 may also be a single layer. The metal plating layer 26 is made of a metal having a thermal conductivity of 50 W/(m-k) or greater. Specifically, the metal plating layer is made of a pure metal such as Ni, Cu, Ag, Sn, or Co, or an alloy containing the pure metal as a main component. These elements have a higher thermal conductivity than titanium. In this embodiment, the metal plating layer 26 may be an Ag plating layer made of pure silver.

The thermal conductivity of the metal constituting the metal plating layer 26 is more preferably 100 W/(m-K) or greater. The thermal conductivity of the metal constituting the metal plating layer 26 is even more preferably 200 W/(m- K) or greater.

The thickness of the metal plating layer 26 is preferably within a range of 0.1 µm or greater and 500 µm or less, and more preferably within a range of 1 µm or greater and 300 µm or less. The thickness of the metal plating layer 26 is even more preferably 0.5 µm or greater and 100 µm or less.

The metal member constituting the metal member layer 27 is preferably made of a metal having an excellent heat conduction property, and the metal member according to this embodiment may be, for example, a rolled plate of oxygen-free copper.

The thickness of the metal member layer 27 (a thickness of the metal member) is preferably within a range of 30 µm or greater and 5,000 µm or less, and more preferably within a range of 50 µm or greater and 3,000 µm or less.

The bonding layer 28 formed between the metal plating layer 26 and the metal member layer 27 is formed of a sintered body of a metal, and in this embodiment, a sintered body of a silver paste containing silver particles or silver oxide particles is used.

The density of the bonding layer 28 is preferably within a range of 60% or greater and 90% or less, and more preferably within a range of 70% or greater and 80% or less in a case where the density is measured by, for example, observing an SEM image. By adjusting the porosity in the bonding layer 28 within the above range, the thermal stress generated during thermal cycle loading can be relaxed in the bonding layer 28.

Next, Fig. 3 shows an observation photograph of a bonding interface between the plate body 21 and the metal plating layer 26 in this embodiment, and Fig. 4 shows a schematic diagram of the bonding interface between the plate body 21 and the metal plating layer 26.

In Fig. 3, the lower black portion corresponds to the plate body 21 (carbonaceous member), and the gray portion positioned above the plate body corresponds to the metal plating layer 26 (for example, Ag plating layer).

In this embodiment, as shown in Figs. 3 and 4, the edge surfaces of the graphite particles are directed to the main surface of the plate body 21. Thus, irregularities are formed on the main surface of the plate body 21, and the plating metal (Ag in this embodiment) of the metal plating layer 26 penetrates into the plate body 21 correspondingly to the irregularities. As a result, the metal plating layer 26 and the plate body 21 are firmly bonded by an effect generally called an anchor effect.

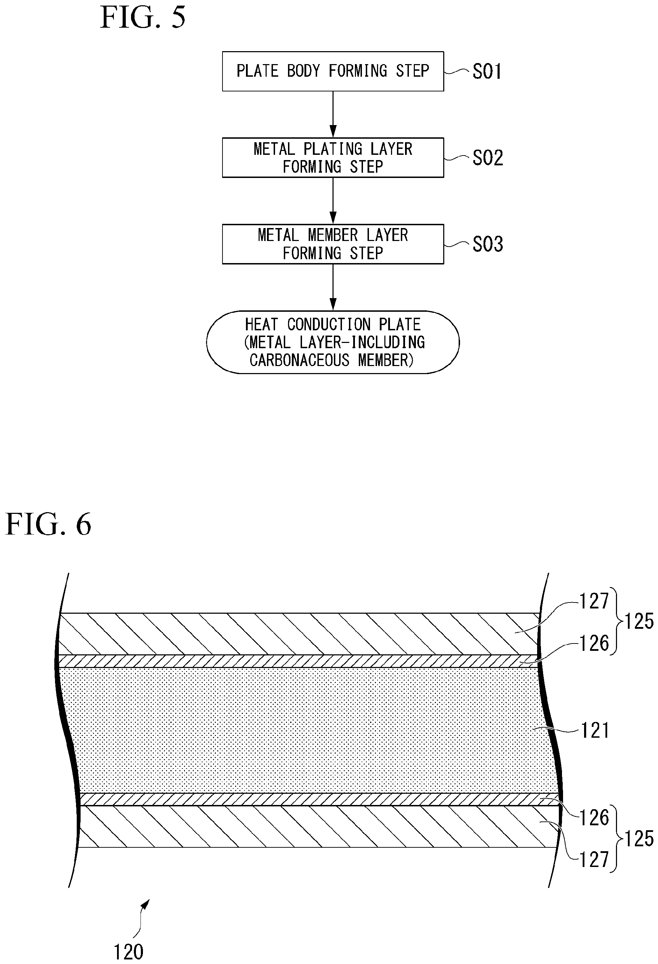

Next, a method of producing the heat conduction plate 20 (metal layer-including carbonaceous member) according to this embodiment will be described with reference to the flowchart shown in Fig. 5.

### (Plate Body Forming Step S01)

First, the flat graphite particles and the graphene aggregates described above are weighed so as to obtain a predetermined blending ratio, and are mixed by an existing mixing device such as a ball mill.

By filling a mold having a predetermined shape with the obtained mixture and pressurizing the mixture, a molded body is obtained. Heating may be performed during pressurization.

The obtained molded body is cut to obtain a plate body 21. In this case, the cutting is performed so that the basal surfaces of the flat graphite particles extend in a thickness direction of the plate body 21 and the edge surfaces of the flat graphite particles are directed to a main surface of the plate body 21.

The pressure during molding is not limited, but is preferably within a range of 20 MPa or greater and 1,000 MPa or less, and more preferably within a range of 100 MPa or greater and 300 MPa or less. The temperature during molding is not limited, but is preferably within a range of 50°C or higher and 300°C or lower. The pressurizing time is not limited, but is preferably within a range of 0.5 minutes or longer and 10 minutes or shorter.

An arithmetic average height Sa of the edge lamination surface is preferably 1.1 µm or greater, and a maximum height Sz of the edge lamination surface is preferably 20 µm or greater. In a case where the above ranges are satisfied, the metal plating layer is more firmly bonded to the irregularities of the edge lamination surface, whereby the bonding strength between the metal plating layer and the carbonaceous member can be further improved.

The arithmetic average height Sa of the edge lamination surface is more preferably 1.1 µm or greater and 5 µm or less, and the maximum height Sz of the edge lamination surface is more preferably 20 µm or greater and 50 µm or less. The arithmetic average height Sa of the edge lamination surface is even more preferably 1.1 µm or greater and 3 µm or less, and the maximum height Sz of the edge lamination surface is even more preferably 20 µm or greater and 40 µm or less. A reference surface for a case where the arithmetic average height Sa and the maximum height Sz of the edge lamination surface are measured may have a size of, for example, 3.02 mm × 3.02 mm. For the measurement of the arithmetic average height Sa and the maximum height Sz, a method of converting interference fringe brightness and darkness information obtained by a white interference microscope into height information can be used.

In order to set each of the arithmetic average height Sa and the maximum height Sz of the edge lamination surface within the predetermined range, the edge lamination surface may be previously subjected to an ozone treatment to be roughened. In a case where the edge lamination surface is subjected to an ozone treatment, the metal plating layer is more firmly bonded to the irregularities of the edge lamination surface roughened by the ozone treatment, whereby the bonding strength between the metal plating layer and the carbonaceous member can be further improved.

The conditions of the ozone treatment for roughening the edge lamination surface are, for example, as follows.

The ozone treatment was performed by irradiating the edge lamination surface with ultraviolet rays for 30 minutes using an ozone cleaning device (Model UV 312, Technovision, Inc.) provided with a low pressure mercury lamp.

A plasma treatment can be used instead of the ozone treatment in order to roughen the edge lamination surface. In that case, as an example of the conditions, a method of performing a plasma treatment by irradiating the graphene with O₂ plasma using a plasma treatment device (plasma dry cleaner "PDC-210" (trade name) manufactured by Yamato Scientific co., ltd.) can be used.

### (Metal Plating Layer Forming Step S02)

Next, a metal plating layer 26 is formed on both the main surfaces of the plate body 21. The plating method is not particularly limited, and a wet plating method such as an electrolytic plating method or an electroless plating method can be applied. In this embodiment, an Ag plating layer may be formed by the electrolytic plating method.

Before the plating is performed, the main surface (edge lamination surface) of the plate body 21 may be subjected to a pretreatment such as a plasma treatment and an oxidation treatment. By performing the pretreatment, the roughened surface state of the edge lamination surface can be controlled.

The plating conditions in the metal plating layer forming step S02 are not limited, but the current density in the electrolytic plating is within a range of 0.1 A/dm² or greater and 10 A/dm² or less, and preferably within a range of 1 A/dm² or greater and 3 A/dm² or less.

The plating liquid is not limited, but a general cyan Ag plating liquid may be used, or additives may be appropriately used. For example, a plating liquid containing silver cyanide (AgCN) within a range of 30 g/L or greater and 50 g/L or less and potassium cyanide (KCN) within a range of 100 g/L or greater and 150 g/L or less can be used.

As described above, due to the fact that the edge surfaces of the graphite particles oriented appropriately are directed to the main surface (edge lamination surface) of the plate body 21, irregularities are formed on the main surface. The metal in the plating liquid enters the irregularities, the plating metal of the metal plating layer 26 penetrates into the plate body 21, and the plate body 21 and the metal plating layer 26 are firmly bonded.

### (Metal Member Layer Forming Step S03)

Next, a metal member is bonded to a surface of the metal plating layer 26 to form a metal member layer 27. In this embodiment, a silver paste containing a silver powder or a silver oxide powder is applied to the surface of the metal plating layer 26. The silver paste contains a silver powder and a solvent. A resin or a dispersant may be optionally contained. Instead of the silver powder, a silver oxide powder and a reducing agent may be contained.

The average particle size of the silver powder and the silver oxide powder is preferably within a range of 10 nm or greater and 10 µm or less, and more preferably within a range of 100 nm or greater and 1 µm or less. The coating thickness of the silver paste is preferably within a range of 10 µm or greater and 100 µm or less, and more preferably within a range of 30 µm or greater and 50 µm or less.

A rolled plate of oxygen-free copper, which is a metal member, is laminated on the silver paste applied as described above. The rolled plate of oxygen-free copper, which is a metal member, and the plate body 21 on which the metal plating layer 26 is formed are pressurized in the lamination direction and heated to bake the silver paste, and thus the metal member and the metal plating layer 26 are bonded.

The pressurizing load during the pressurization is not limited, but is preferably within a range of 5 MPa or greater and 30 MPa or less, and the heating temperature is preferably within a range of 150°C or higher and 280°C or lower. In this embodiment, the holding time at the above-described heating temperature and the atmosphere are not limited, but the holding time is preferably within a range of 3 minutes or longer and 20 minutes or shorter, and the atmosphere is preferably a non-oxidation atmosphere.

A bonding layer 28 formed of a sintered body of silver is formed between the metal member layer 27 and the metal plating layer 26, and by defining the bonding conditions as described above, the porosity in the bonding layer 28 is adjusted within, for example, a range of 70% or greater and 80% or less.

Through the above steps, a heat conduction plate 20 (metal layer-including carbonaceous member) according to this embodiment is produced.

According to the heat conduction plate 20 (metal layer-including carbonaceous member) of this embodiment, the carbonaceous member constituting the plate body 21 contains graphene aggregates formed by deposition of a single layer or multiple layers of graphene, and flat graphite particles, has a structure in which the flat graphite particles are laminated with the graphene aggregate as a binder so that the basal surfaces of the graphite particles overlap with one another, and is disposed so that the basal surfaces of the graphite particles extend along the thickness direction of the plate body. Accordingly, the thermal conductivity of the plate body 21 (carbonaceous member) in the thickness direction increases.

The edge surfaces of the graphite particles are directed to the main surface of the plate body 21, and thus irregularities are formed on the main surface of the plate body.

Since the metal plating layer 26 is formed on the main surface (edge lamination surface) of the plate body 21 on which the irregularities are formed, the plating metal of the metal plating layer 26 sufficiently penetrates into the plate body 21 (carbonaceous member) as shown in Fig. 3, and the metal plating layer 26 and the plate body 21 (carbonaceous member) are firmly bonded by an anchor effect of the roughened surface.

The metal plating layer 26 is made of a metal having a thermal conductivity of 50 W/(m-K) or greater. Specifically, the metal plating layer is made of a pure metal such as Ni, Cu, Ag, Sn, or Co, or an alloy containing the pure metal as a main component. In this embodiment, since the metal plating layer 26 is an Ag plating layer, it does not provide heat resistance.

Accordingly, the heat from the heating element (the insulating circuit board 10 mounted with the semiconductor element 3) mounted on the metal layer 25 can be efficiently conducted in the thickness direction of the plate body 21.

In this embodiment, the metal layer 25 includes the metal plating layer 26 and the metal member layer 27 formed of a metal member bonded to the metal plating layer 26. Accordingly, the thickness of the metal layer 25 is secured, the heat from the heating element (the insulating circuit board 10 mounted with the semiconductor element 3) can be sufficiently diffused in the surface direction along the metal layer 25, and the heat conduction characteristics can be further improved. Furthermore, since the bonding between the metal plating layer 26 and the metal member layer 27 is bonding between the metals, sufficient bonding strength can be secured.

In this embodiment, the bonding layer 28 formed of a sintered body of a metal is formed between the metal plating layer 26 and the metal member layer 27. Accordingly, the thermal stress generated in a case where thermal cycle is loaded on the heat conduction plate 20 (metal layer-including carbonaceous member) can be relaxed in the bonding layer 28, and the damage to the heat conduction plate 20 (metal layer-including carbonaceous member) during thermal cycle loading can be suppressed.

In particular, in this embodiment, in a case where the porosity in the bonding layer 28 is within a range of 70% or greater and 80% or less, the thermal stress can be securely relaxed, and it is possible to suppress that the bonding layer 28 provides heat resistance.

In this embodiment, since the metal layer 25 is formed on both the main surfaces of the plate body 21, it is possible to suppress the warping of the plate body 21 by the heat history during the formation of the metal layer 25.

In this embodiment, since irregularities are formed on both the main surfaces of the plate body, an anchor effect is exhibited between the metal plating layer 26 and the plate body 21. Accordingly, the bonding strength between the metal plating layer 26 and the plate body 21 (carbonaceous member) can be sufficiently improved.

In this embodiment, the heat conduction plate 20 is disposed between the insulating circuit board 10 and the heat sink 30. Accordingly, in the metal layer 25 formed on one main surface side of the heat conduction plate 20, the heat from the insulating circuit board 10 can be diffused in the surface direction, and efficiently transferred in the thickness direction. Whereby, the heat can be radiated in the heat sink 30. Accordingly, a power module 1 having excellent heat radiation characteristics can be constituted.

The embodiments of the present invention have been described as above, but the present invention is not limited thereto, and can be appropriately without departing from the technical ideas of the invention.

For example, in this embodiment, the configuration in which a semiconductor element (power semiconductor element) is mounted on the circuit layer of the insulating circuit board to constitute a power module has been described, but the present invention is not limited thereto. For example, an LED element may be mounted on the insulating circuit board to constitute an LED module, or a thermoelectric element may be mounted on the circuit layer of the insulating circuit board to constitute a thermoelectric module.

In this embodiment, the configuration in which the metal plating layer and the metal member layer are bonded using a metal paste has been described, but the present invention is not limited thereto. The method of bonding the metal plating layer to the metal member layer (metal member) is not particularly limited, and various existing methods such as a brazing method and a diffusion bonding method can be applied.

For example, as in a case of a heat conduction plate 120 (metal layer-including carbonaceous member) shown in Fig. 6, in a case where one of a metal plating layer 126 and a metal member layer 127 is made of aluminum or an aluminum alloy, and the other of the metal plating layer 126 and the metal member layer 127 is made of copper or a copper alloy, the metal plating layer 126 and the metal member layer 127 may be bonded by solid phase diffusion bonding. In this case, a plurality of types of copper-aluminum intermetallic compounds are formed in layers at the bonding interface between the metal plating layer 126 and the metal member layer 127.

In this embodiment, the power module 1 having a structure in which the heat conduction plate 20 is disposed between the insulating circuit board 10 and the heat sink 30 as shown in Fig. 1 has been described as an example. However, the present invention is not limited thereto, and there is no particular limitation on the method of using the heat conduction plate (metal layer-including carbonaceous member) according to the present invention.

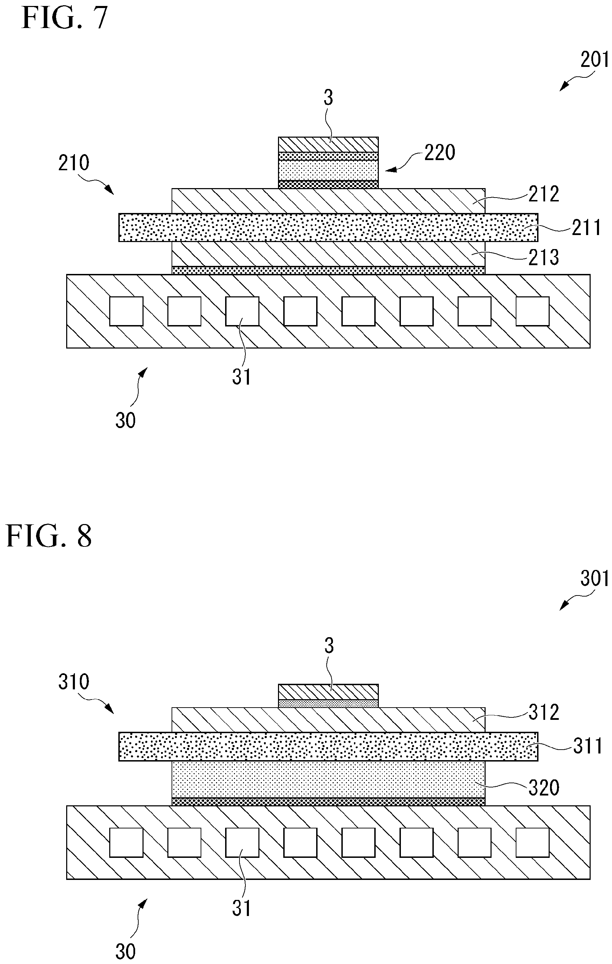

For example, as in a case of a heat conduction plate 220 (metal layer-including carbonaceous member) shown in Fig. 7, a structure in which the heat conduction plate may be disposed between a circuit layer 212 of an insulating circuit board 210 and a semiconductor element 3 may be provided. In this case, by constituting a metal layer 225 of the heat conduction plate 220 (metal layer-including carbonaceous member) with, for example, Sn, the semiconductor element 3 and the circuit layer 212 can be bonded to the heat conduction plate 220 (metal layer-including carbonaceous member) using a solder material.

Furthermore, as in a heat conduction plate 320 (metal layer-including carbonaceous member) shown in Fig. 8, the heat conduction plate 320 (metal layer-including carbonaceous member) may be used as a heat transfer layer of an insulating circuit board 310. That is, a circuit layer 312 may be formed on one surface of an insulating layer 311, and the heat conduction plate 320 according to the present invention may be bonded to the other surface of the insulating layer 311 to constitute the insulating circuit board 310.

### EXAMPLES

Confirmation experiments performed to confirm the effectiveness of the present invention will be described.

### [Experiment 1]

As disclosed in this embodiment, flat graphite particles and graphene aggregates were blended at a predetermined blending ratio and mixed. The mixture was heated under pressure and molded to obtain a molded body having a structure in which the flat graphite particles were laminated with the graphene aggregate as a binder so that the basal surfaces of the graphite particles overlapped with one another.

The average particle size of the graphite particles viewed toward the basal surface was 100 µm as measured by a line segment method. The average thickness of the graphite particles was 3 µm as measured by the line segment method. The graphene aggregate was 10 layers of graphene on average as confirmed within the visual field range of an electron microscope. The average particle size of the graphene aggregate was 5 µm as measured by the line segment method, and the average thickness of the graphene aggregate was 10 µm.

The obtained molded body was cut so that the basal surfaces of the flat graphite particles extended in a thickness direction of the plate body and the edge surfaces of the flat graphite particles were directed to a main surface of the plate body.

By the method described in this embodiment, an Ag plating layer (thickness: 2 µm) was directly formed on the surface (edge lamination surface) of the plate body to which the edge surfaces were directed, and a heat conduction plate (metal layer-including carbonaceous member) was obtained. In the obtained heat conduction plate, the adhesion of the metal layer was evaluated with reference to JIS K 5600-5-6 (adhesion test (cross-cut method)). After the formation of the metal layer, evaluation was performed as follows: the metal layer was subjected to cross-cut in a grid pattern at intervals of 100 µm, and a transparent tape was stuck on the metal layer subjected to the cross-cut to confirm whether the metal layer was peeled off as the tape was peeled off. As a result, it was confirmed that the metal layer was not peeled off, and the metal layer and the carbonaceous member were firmly bonded.

From the above description, according to the present invention, it was confirmed that it is possible to provide a metal layer-including carbonaceous member (heat conduction plate) in which a metal layer and a carbonaceous member are firmly bonded without interposition of titanium and which can efficiently conduct heat.

### [Experiment 2]

In order to prepare heat conduction plates of Examples 1 and 2 and Comparative Examples 1 and 2, carbonaceous members each having an arithmetic surface height Sa and a maximum height Sz shown in Table 1 were prepared. An ozone treatment was performed in Example 1 to increase the arithmetic surface height Sa.

In the molded body used for Example 1, the edge lamination surface was roughened by performing an ozone treatment under the following conditions.

Ozone Treatment Conditions: The ozone treatment was performed by irradiation with ultraviolet rays for 30 minutes.

The edge lamination surfaces of the molded bodies used for Examples 1 and 2 and Comparative Examples 1 and 2, respectively, were observed by a white interference microscope (using 0.5 times of 5.5x zoom), and a visual field region of 3.02 mm × 3.02 mm was photographed to measure an arithmetic average height Sa and a maximum height Sz of the edge lamination surface from the interference fringe. The results are shown in Table 1.

Next, on the edge lamination surface, a metal of a metal plating type shown in Table 1 was directly formed in an average thickness of 2 µm, and heat conduction plates (metal layer-including carbonaceous member) of Examples 1 and 2 and Comparative Examples 1 and 2 were obtained.

A cross-cut test was performed on the heat conduction plates of Examples 1 and 2 and Comparative Examples 1 and 2 in the same manner as in Experiment 1 to evaluate the adhesion of the metal layer. The results are collectively shown in Table 1.

**[Table 1]**

| | Ozone Treatment | Metal Plating Type | Arithmetic Average Height Sa (µm) | Maximum Height Sz (µm) | Presence or Absence of Peeling |
|---|---|---|---|---|---|
| Example 1 | Treated | Cu | 2.3 | 20.6 | Not Peeled |
| Example 2 | Untreated | Ag | 1.1 | 29.8 | Not Peeled |
| Comparative Example 1 | Untreated | Ag | 0.9 | 54.8 | Peeled |
| Comparative Example 2 | Untreated | Cu | 1.4 | 13.5 | Peeled |

As shown in Table 1, in Examples 1 and 2 in which the arithmetic average height Sa of the edge lamination surface was 1.1 µm or greater and the maximum height Sz was 20 µm or greater, the metal plating layer was not peeled off. However, in Comparative Examples 1 and 2 which did not satisfy the conditions where the arithmetic average height Sa of the edge lamination surface was 1.1 µm or greater and the maximum height Sz was 20 µm or greater, peeling occurred. It was possible to confirm good bonding strength also in Example 1 in which the edge lamination surface was subjected to the ozone treatment.

### INDUSTRIAL APPLICABILITY

According to the present invention, since it is possible to provide a metal layer-including carbonaceous member in which a metal layer and a carbonaceous member are firmly bonded and which can efficiently conduct heat, and a heat conduction plate using the metal layer-including carbonaceous member, the present invention can be used industrially.

### REFERENCE SIGNS LIST

20, 120, 220, 320: Heat conduction plate (metal layer-including carbonaceous member)
21,121: Plate body (carbonaceous member)
25,125: Metal layer
26,126: Metal plating layer
27,127: Metal member layer
28: Bonding layer

## Claims

1. A metal layer-including carbonaceous member comprising:
a carbonaceous member; and
a metal layer formed on at least a part of a surface of the carbonaceous member,
wherein the carbonaceous member contains graphene aggregates formed by deposition of a single layer or multiple layers of graphene, and flat graphite particles, and has a structure in which the flat graphite particles are laminated with the graphene aggregate as a binder so that basal surfaces of the graphite particles overlap with one another, and the basal surfaces of the flat graphite particles are oriented in one direction,
the metal layer includes a metal plating layer directly formed on an edge lamination surface to which edge surfaces of the graphite particles laminated in the carbonaceous member are directed, and
the metal plating layer is made of a metal having a thermal conductivity of 50 W/(m- K) or greater.

2. The metal layer-including carbonaceous member according to Claim 1,
wherein the metal layer includes the metal plating layer and a metal member layer formed of a metal member bonded to the metal plating layer.

3. The metal layer-including carbonaceous member according to Claim 2,
wherein a bonding layer formed of a sintered body of a metal is formed between the metal plating layer and the metal member layer.

4. The metal layer-including carbonaceous member according to any one of Claims 1 to 3,
wherein an arithmetic average height Sa of the edge lamination surface is 1.1 µm or greater, and a maximum height Sz of the edge lamination surface is 20 µm or greater.

5. A heat conduction plate which diffuses heat from a heating element mounted on a main surface in a surface direction and conducts the heat in a thickness direction, the heat conduction plate comprising:
the metal layer-including carbonaceous member according to any one of Claims 1 to 4,
wherein the carbonaceous member is disposed so that the basal surfaces of the graphite particles extend in the thickness direction, and the metal plating layer is formed on the main surface to which the edge surfaces of the graphite particles are directed.
